# EUROPÄISCHE PATENTSCHRIFT

(11) **EP 2 294 902 B1**
(45) Veröffentlichungstag und Bekanntmachung des Hinweises auf die Patenterteilung: **02.11.2011**
(21) Anmeldenummer: 09757480.0
(22) Anmeldetag: 29.05.2009
(51) Int. Cl.: H05K 1/02, H01L 23/36

(54) **KÜHLSYSTEM FÜR LED-CHIP-ANORDNUNG**
COOLING SYSTEM FOR AN LED CHIP ARRAY
SYSTÈME DE REFROIDISSEMENT POUR DISPOSITIF À PUCES DEL

(30) Priorität: 03.06.2008 DE 102008026627
(43) Veröffentlichungstag der Anmeldung: 16.03.2011
(73) Patentinhaber: Siemens Aktiengesellschaft, 80333 München (DE)
(72) Erfinder: GERHARD, Detlef, 81829 München (DE)
(86) Internationale Anmeldenummer: PCT/EP2009/056636
(87) Internationale Veröffentlichungsnummer: WO 2009/147099

(56) Entgegenhaltungen:
- WO-A1-2005/001943
- WO-A1-2007/148280
- WO-A1-2008/061468
- JP-A- 2006 100 052
- US-A1- 2005 083 698
- US-A1- 2007 290 328
- US-A1- 2008 013 334

## Beschreibung

Die Erfindung betrifft den Aufbau von Hochleistungs-Beleuchtungssystemen auf LED-Basis (Licht emittierende Dioden), wobei einerseits leistungsstarke LED-Chips verwendet werden und andererseits versucht durch wird eine dichte Packung der LED-Chips derart darzustellen, dass möglicht viel Licht auf kleiner Fläche erzeugbar ist. Dabei spielt die Kühlung bzw. Wärmeabfuhr der LED-Chips, die auch als Entwärmung bezeichnet wird, eine große Rolle, da Abhängigkeiten zu Lebensdauer, Effizienz und spektralen Eigenschaften der LED-Chips bestehen.

Bei Verwendung mehrerer LED-Chips auf kleiner Fläche wird mittels Materialien mit hohen Wärmeleiteigenschaften versucht, die im Chip entstehende Wärme über das Material abzuführen. Zusätzlich geschieht dies auch über entsprechende VIAS, elektrische Kontakte in einer Leiterplatte, beispielsweise zu einer darunter liegenden Ebene, wobei ebenso Wärme nach außen abgeleitet wird. Aufgrund der Anordnung der Chips auf einer Ebene soll die Wärme im Wesentlichen über VIAs (Durchgänge) oder Wärmeleitbrücken nach unten abgeleitet werden.

Oft werden sehr gut Wärme leitfähige Isolierschichten eingesetzt, die jedoch mit hohen Kosten verbunden sind. Damit kann Wärme von der Chipebene nach unten weitergeleitet werden. Allerdings liegt der Wärmeleitkoeffizient bei 0,1 bis 1 W/mK. Ein idealer Wärme leitender aber auch Preis intensiver und schlecht zu verarbeitender Werkstoff wäre beispielsweise Diamant.

Eine Wärmeableitung über die Bonddrähte ist zwar auch vorhanden, ist aber gegenüber der Entwärmung über die Rückseite des LED-Chips eher unbedeutend.

Weiterhin werden Wärmeableitungen in Form von vergleichsweise großvolumigen Kühlkörpern verwendet, welche auf der Rückseite einer Mehrlagenleiterplatte zur Montage von LEDs Verwendung finden. Derartige Wärmeableitungen lassen sich beispielsweise der US 2007/0007558 A1 und aus der US 2006/0180821 A1 entnehmen.

Außerdem ist es auch möglich, sogenannte MCPCB's (Metal Core Printed Circuit Boards) zu verwenden, um eine Wärmeableitung zu realisieren. Die Leuchtdioden werden dann auf den MCPCB's montiert, wobei die Wärmeableitung über den metallischen Kern in der Leiterplatte erfolgt. Eine derartige Anordnung ist beispielsweise in der US 2006/0279671 A1 beschrieben. Diese Leiterplatten können in einem Gehäuse derart aufgehängt sein, dass eine Wärmeableitung über den metallischen Kern über eine mechanische Verbindung in das Gehäuse ermöglicht wird. Auf diese Weise lässt sich die Wärme aus dem MCPCB endgültig ableiten. Eine derartige Anordnung ist beispielsweise in der US 6,501,662 B2 beschrieben.

Alternativ ist es möglich, auf Leiterplatten wärmeleitende Schichten aufzubringen. Diese können auch verwendet werden, wenn auf der Leiterplatte LEDs befestigt sind. Eine wärmeableitende Beschichtung für Leiterplatten ist beispielsweise aus der US 6,222,732 B1 bekannt. Aus der US 2008/0013334 A1 ist es zudem bekannt, dass LEDs auch in einem stufenförmigen Aufbau zueinander angeordnet werden können. Zu diesem Zweck werden mehrere Träger für die zum Einsatz kommenden LEDs übereinander angeordnet und derart mit Aussparungen versehen, dass sich eine konzentrische, stufenförmige Anordnung von LEDs in den mittleren Aussparungen der Leiterplatten realisieren lässt.

Einen stufigen Aufban zeigt auch die WO-A-2008/061468, die den nächstliegenden Stand der Technik zeigt, wobei Rippen eines kühlkörpergehäuses der Wärmeabfuhr von der Leiterplatten dienen.

Der Erfindung liegt die Aufgabe zugrunde, für flächig ausgebildete LED-Anordnungen zur Darstellung von LED-Flächenstrahlern eine effektive Kühlung bereit zu stellen.

Die Lösung dieser Aufgabe geschieht durch die Merkmalskombination entsprechend Anspruch 1. Vorteilhafte Ausgestaltungen können den Unteransprüchen entnommen werden.

Das Wesentliche der Erfindung besteht in der Nutzung der Metalllagen der Multilayer-Leiterplatte/Mehrlagenleiterplatte zur Entwärmung der LED-Chips, wobei die Multilayer-Leiterplatte stufenförmig ohne LED-Besetzung strukturiert ist, so dass an offen liegenden großflächigen Bereichen der Metallschichten die Wärme direkt auf einen Kühlkörper weitergeleitet werden kann. Hierdurch stehen sehr großflächige Wärme leitende Verbindungen zur Verfügung.

Die von den Chips auf die Metalllage abgegebene Wärme wird von der Metalllage direkt im Wesentlichen lateral weiter geleitet. Die Metalllage wirkt auch wie eine Wärmekapazität, die die Wärmeenergie aufnimmt und über die Fläche verteilt. Üblicherweise sind die Metalllagen von Multilayer-Platinen aus Kupfer oder einer Kupferlegierung. Kupfer ist ein sehr guter Wärmeleiter, über den die Wärme des Chips schnell weitergeführt wird. Die Entwärmung der Chips über die Metallschicht ist effektiver als der Wärmeübergang von Metall auf Luft oder Metall auf Wasser. Mit dickerer Metallbeschichtung werden die Wärmekapazität und der Wärmetransport zusätzlich günstig beeinflusst.

Wird für die Wärmeableitung ein elektrisch leitender Kühlkörper verwendet, so ist es vorteilhaft zwischen Metalllage der Multilayer-Platine und einem Kühlkörper eine elektrisch nicht leitende Trennschicht vorzusehen. Bei dieser Trennschicht kann es sich um ein Halbleitermaterial, z.B. Silizium, handeln.

Die Multilayer-Platine enthält Durchbrüche, mittels derer die Kühlsysteme von Unter- und Oberseite vorteilhaft miteinander in Verbindung können.

Im Folgenden werden anhand der begleitenden die Erfindung nicht einschränkenden schematischen Figuren Ausführungsbeispiele beschrieben.
- Figur 1: zeigt den Prinzipaufbau für eine Wärmeableitung und Kühlkörpermontage an einer mit LEDs bestückten Leiteplatte,
- Figur 2: zeigt ein Schnittbild einer Multilayer-Platine mit einer besonderen Art der Wärmeableitung.

Durch eine stufenförmige Anordnung der LED-Chips auf mehrere Ebenen einer Multilayer-Platine mit entsprechender LED-Besetzung verteilt sich die Wärme der LED-Chips auf mehrere Lagen bzw. Ebenen. Hierbei liegt mindestens ein LED-Chip des Chip-Arrays auf einer Metalllage der Multilayer-Platine. Die LED-Chips sind beispielsweise mit einem leitenden Kleber mit der Metalllage verbunden. Die Art der Verbindung 6 spielt keine Rolle, solange über die Verbindung zwischen Chiprückseite und Metalllage genügend Wärme transportiert werden kann.

Im folgende sind nochmals die technischen Merkmale aufgeführt, die der Erfindung zugrunde liegen:

Es wird der Umstand genutzt, dass die LED-Chips 8 auf mehreren Lagen der Multilayer-Platine positioniert sind.

Die Multilayer-Platine ist so ausgeführt, dass größere Flächenanteile der einzelnen Lagen, auf denen die LED-Chips jeweils positioniert sind, freigelegt sind und so ein Teil eines Kühlsystems bilden. Eine LED besetzte stufenförmige Struktur liegt dabei einer stufenförmigen Struktur mit großflächigen frei gelegten Kontaktflächen für die Aufbringung von Kühlkörpern ungefähr gegenüber.

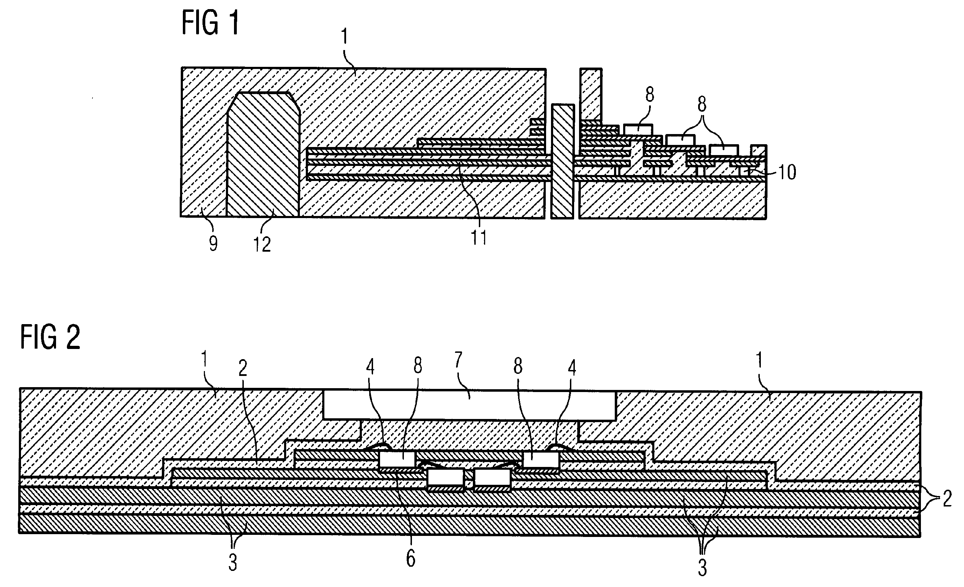

Ein Schnitt durch die Multilayer-Platine zeigt die stufenförmige Auslegung der Multilayer-Platine, wie in Figur 2 sichtbar.

Die unterste Lage der Multilayer-Platine kann eine Metalllage sein, über welche auch von unten ein Kühlkörper angebracht sein kann.

Die Wärmeleitung auf die unterste Seite, findet über VIAs 10 statt, wobei VIAs beispielsweise von der Metalllage, die mit zu entwärmenden LED-Chips besetzt ist, auf die unterste Metalllage der Platine führen.

Metalllagen, die zwischen der zu entwärmenden Metalllage und der untersten Metalllage liegen, sind gegenüber den VIAs isoliert.

Auf der Rückseite oder Vorderseite ist ein Verbindungsstecker montiert, über welchen zusätzlich ein Teil der Wärme zum Anschlusskabel abgeleitet wird.

Optional wird mit einem sogenannten Starrflex-Aufbau die Wärme über eine flexible Leiterplatte, welche an der zu entwärmenden Leiterplatte angeschlossen ist, abgeleitet.

In den Kühlkörper, der auf der Oberseite der zu entwärmenden Leiterplatte montiert ist, ist ein Teil 7 der zugehörigen Optik für ein LED-System integriert.

Der Kühlkörper 1 besitzt zur Weiterleitung der Wärme eine Verbindungsmöglichkeit, z.B. ein oder mehrere Gewinde oder Stifte, über welche die Wärme an weitere Objekte bzw. Wärmesenken weitergegeben werden kann.

Ein Kühlkörper kann auf der Leiterplatte 11 montiert sein, wobei für elektrisch leitende Kühlkörper zwischen Kühlkörper und Metalllage der Multilayer-Platine eine gut Wärme leitende aber elektrisch isolierende Zwischenlage aufgebracht ist.

VIAs führen die Wärme auch auf die untere Metalllage ab. Die VIAs besitzen bei Bedarf nur zwischen der zu entwärmenden Metalllage, die mindestens einen zu entwärmenden LED-Chip aufweist, und der unteren Metalllage, an der ein Kühlkörper angebracht sein kann, eine elektrische Verbindung.

Eine Multilayer-Leiterplatte 11 ist so aufgebaut, dass die Metalllagen 3 auf denen die LED-Chips aufgebracht sind stufenförmig herausgeführt werden, so dass die Metalllage nach oben großflächig für Kühlkörper 1 zugänglich sind.

Figur 1 zeigt den Prinzipaufbau für eine Wärmeableitung und Kühlkörpermontage an einer mit LEDs bestückten Mehrlagenleiteplatte, wobei die LED-Chips 8 auf stufenförmigen Ausbildungen der Mehrlagenleiterplatte 11 aufgebracht sind. Kühlkörper 1,9 können oberhalb der Leiterplatte und unterhalb der Leiterplatte positioniert sei.

Zunächst ist der obere Kühlkörper 1 an eine stufenförmige Ausbildung der Mehrlagenleiterplatte angepasst und gut Wärme leitend damit verbunden. Der untere Kühlkörper ist über VIAs 10 mit dem oberen Kühlkörper 1 Wärme leitend verbunden. Es ist auch möglich, die Mehrlagenleiterplatte insgesamt, oben und unten, mit stufenförmigen Konstruktionen zu versehen, so dass auch untere Kühlkörper 9 entsprechend ausgebildet werden. Verbindungselemente 12 bieten gute Positioniereigenschaften.

Geringe Mengen Abwärme können zusätzlich über die Bonddrähte 4 abgeführt werden. Die Metalllagen der Leiterplatte sind natürlich durch Isolationsschichten 2 voneinander getrennt.

## Patentansprüche

1. Kühlsystem für mindestens eine LED-Chip-Anordnung auf einer Mehrlagenleiterplatte (11), welches Folgendes umfasst:
- eine Mehrlageleiterplatte mit für die Chip-Positionierung nach außen frei gelegten stufenförmig strukturierten Metalllagen (3) zur Darstellung von LED-Anordnungen,
- mehrere direkt auf den frei gelegten Metalllagen gut Wärme leitend aufgebrachte LED-Chips (8),
- mindestens eine stufenförmig ausgebildete ausgehend von den LEDs nach außen gerichtete Struktur der mit LEDs besetzten Metalllagen mit großflächig dargestellten Bereichen der Metalllagen,
- mindestens einen Kühlkörper (1), welcher auf den frei gelegten großflächigen Metalllagen über eine elektrisch nicht leitende Schicht (2) mit hoher Wärmeleitfähigkeit angekoppelt ist.

2. Kühlsystem nach Anspruch 1, bei dem
sowohl auf der Oberseite, als auch auf der Unterseite der Mehrlagenleiterplatte (11), mindestens ein Kühlkörper (1,9) vorgesehen ist.

3. Kühlsystem nach Anspruch 2, bei dem
die unterste Lage der Mehrlagenleiterplatte eine Metalllage ist, über die von unten der Kühlkörper angebracht wird.

4. Kühlsystem nach einem der Ansprüche 1 bis 3, bei dem zur zusätzlichen Wärmeabfuhr Durchkontaktierungen, sogenannte VIAs (10), vorgesehen sind.

5. Kühlsystem nach 4, bei dem
VIAs gegenüber ausgewählten Metalllagen elektrisch isoliert sind.

6. Kühlsystem nach einem der Ansprüche 4 oder 5, bei dem VIAs von der Metalllage mit zu entwärmenden LED-Chips auf die unterste Metalllage der Mehrlagenleiterplatte (11) führen.

7. Kühlsystem nach einem der Ansprüche 1 bis 6, bei dem zusätzlich über Verbindungsstecker und Anschlusskabel Wärme von LEDs abführbar ist.

8. Kühlsystem nach einem der Ansprüche 1 bis 7, bei dem Zusätzlich über eine sogenannte flexible Leiterplatte, welche an der zu entwärmenden Leiterplatte angeschlossen ist, Wärme abführbar ist.

9. Kühlsystem nach einem der Ansprüche 1 bis 8, bei dem die Mehrlagenleiterplatte pyramidenförmig ausgebildet ist.

10. Kühlsystem nach einem der Ansprüche 1 bis 9, bei dem die elektrisch nicht leitende Schicht über die der Kühlkörper angekoppelt ist und / oder der Kühlkörper selbst aus Halbleitermaterial besteht.

11. Kühlsystem nach einem der Ansprüche 1 bis 10, bei dem Der Kühlkörper derart gestaltet ist, dass die Lichtabstrahlung nicht behindert ist.

12. Kühlsystem nach einem der Ansprüche 1 bis 11, bei dem Der Kühlkörper Teil eines optischen Systems ist oder Teile einer Optik aufnimmt.

## Claims

1. Cooling system for at least one LED chip arrangement on a multilayer printed circuit board (11), comprising the following:
- a multilayer printed circuit board having metal layers (3) which are structured in a stepped fashion and are exposed towards the outside for chip positioning, for the production of LED arrangements,
- a plurality of LED chips (8) applied directly on the exposed metal layers in a manner exhibiting good thermal conductivity,
- at least one structure - embodied in a stepped fashion and directed towards the outside proceeding from the LEDs - of the metal layers occupied by LEDs with regions of the metal layers which are produced in a large-area fashion,
- at least one heat sink (1) coupled on the exposed large-area metal layers by means of an electrically non-conductive layer (2) with high thermal conductivity.

2. Cooling system according to Claim 1, wherein
at least one heat sink (1, 9) is provided both on the top side and on the underside of the multilayer printed circuit board (11).

3. Cooling system according to Claim 2, wherein
the bottommost layer of the multilayer printed circuit board is a metal layer by means of which the heat sink is fitted from below.

4. Cooling system according to any of Claims 1 to 3, wherein plated-through holes, so-called VIAs (10), are provided for additional heat dissipation.

5. Cooling system according to Claim 4, wherein
VIAs are electrically insulated from selected metal layers.

6. Cooling system according to either of Claims 4 and 5, wherein
VIAs lead from the metal layer with LED chips from which heat is to be dissipated to the bottommost metal layer of the multilayer printed circuit board (11).

7. Cooling system according to any of Claims 1 to 6, wherein heat can additionally be dissipated from LEDs by means of connecting plugs and connection cables.

8. Cooling system according to any of Claims 1 to 7, wherein heat can additionally be dissipated by means of a so-called flexible printed circuit board, which is connected to the printed circuit board from which heat is to be dissipated.

9. Cooling system according to any of Claims 1 to 8, wherein the multilayer printed circuit board is embodied in a pyramidal fashion.

10. Cooling system according to any of Claims 1 to 9, wherein the electrically non-conductive layer by means of which the heat sink is coupled and/or the heat sink itself consist(s) of semiconductor material.

11. Cooling system according to any of Claims 1 to 10, wherein the heat sink is configured in such a way that the light emission is not impeded.

12. Cooling system according to any of Claims 1 to 11, wherein the heat sink is part of an optical system or accommodates parts of an optical arrangement.

## Revendications

1. Système de refroidissement pour un dispositif à puce DEL sur une plaque ( 1 ) à circuit imprimé à plusieurs couches, qui comprend ce qui suait :
- une plaquette à circuit imprimé à plusieurs couches ayant, pour la représentation de dispositifs DEL, des couches ( 3 ) métalliques structurées en forme de palier mises à nu vers l'extérieur pour le positionnement de puces,
- plusieurs puces ( 8 ) DEL déposées d'une manière bonne conductrice de la chaleur directement sur les couches métalliques mises à nu,
- au moins une structure en forme de palier, dirigée vers l'extérieur en partant des DEL, des couches métalliques occupées par des DEL avec des zones de grande surface des couches métalliques,
- au moins un dissipateur ( 1 ) de chaleur, qui est couplé sur les couches métalliques de grande surface mises à nu par une couche ( 2 ) non conductrice de l'électricité d'une grande conductibilité thermique.

2. Système de refroidissement suivant la revendication 1, dans lequel
il est prévu au moins un dissipateur ( 1, 9 ) de chaleur, à la fois sur la face supérieure et sur la face inférieure de la plaquette ( 11 ) à circuit imprimé à plusieurs couches.

3. Système de refroidissement suivant la revendication 2, dans lequel
la couche la plus basse de la plaquette à circuit imprimé à plusieurs couches est une couche métallique sur laquelle le dissipateur de chaleur est mis par en dessous.

4. Système de refroidissement suivant l'une des revendications 1 à 3, dans lequel
il est prévu pour l'évacuation supplémentaire de chaleur des traversées, ce que l'on appelle des VIAs ( 10 ).

5. Système de refroidissement suivant la revendication 4, dans lequel
les VIAs sont isolées électriquement par rapport à des couches métalliques sélectionnées.

6. Système de refroidissement suivant l'une des revendications 4 ou 5, dans lequel
des VIAs vont de la couche métallique ayant des puces DEL dont il faut évacuer de la chaleur à la couche métallique la plus basse de la plaquette ( 11 ) à circuit imprimé à plusieurs couches.

7. Système de refroidissement suivant l'une des revendications 1 à 6, dans lequel
de la chaleur des DELS peut être évacuée supplémentairement par des connecteurs et des câbles de raccordement.

8. Système de refroidissement suivant l'une des revendications 1 à 7, dans lequel
de la chaleur peut être évacuée supplémentairement par ce que l'on appelle une plaquette à circuit imprimé souple, qui est raccordée à la plaquette à circuit imprimé dont il faut évacuer de la chaleur.

9. Système de refroidissement suivant l'une des revendications 1 à 8, dans lequel
la plaquette à circuit imprimé a plusieurs couches est en forme de pyramide.

10. Système de refroidissement suivant l'une des revendications 1 à 9, dans lequel
la couche non conductrice de l'électricité est couplée au dessus de celle du dissipateur de chaleur et/ou le dissipateur de chaleur soi même est en un matériau semiconducteur.

11. Système de refroidissement suivant l'une des revendications 1 à 10, dans lequel
le dissipateur de chaleur est conformé de manière à ne pas gêner l'émission de lumière.

12. Système de refroidissement suivant l'une des revendications 1 à 11, dans lequel le dissipateur de chaleur fait partie d'un système optique ou reçoit des parties d'une optique.
